# EUROPEAN PATENT APPLICATION

(11) **EP 4 845 342 A1**
(43) Date of publication of application: **25.11.2026**
(21) Application number: 26171469.5
(22) Date of filing: 09.04.2026
(51) Int. Cl.: H10D 64/01, H10D 64/62, H10D 62/832, H10H 20/832

(54) **GRAPHENE CONTACT LAYER ON SIC SUBSTRATE AND METHOD OF MANUFACTURING THE SAME**

(30) Priority: 20.05.2025 SE 2550499
(71) Applicant: STMicroelectronics International N.V., 1228 Plan-les-Ouates, Geneva (CH)
(72) Inventor: MAGNUSSON LINDGREN, Björn, 60379 NORRKÖPING (SE)
(74) Representative: Studio Torta S.p.A.

(57) **Abstract**

A stacked semiconductor structure (e.g., a wafer structure or substrate structure) that includes a graphene layer (202) that is formed between a backside contact (206), a semiconductor substrate (204), one or more epitaxial layers, and one or more device layers (208). The backside contact is made of one or more metal conductive layers and is on an opposite side of the semiconductor substrate relative to the one or more epitaxial layers and the one or more devices layers. The semiconductor substrate is made of a silicon-carbide (SiC) material. The graphene layer strengthens an adhesion strength preventing peeling of the backside contact from the stacked semiconductor structure, as well as reduces resistivity of the stacked semiconductor structure providing an electrical pathway that efficiently, effectively, and accurately allows for electrical signals to pass through the stacked semiconductor structure.

## Description

### BACKGROUND

### Technical Field

The present disclosure is directed to a graphene layer or graphene contact layer with a randomly oriented layers on a respective surface of a silicon carbide (SiC) substrate, and a method of manufacturing the graphene layer or graphene contact layer on the respective surface of the silicon carbide (SiC) substrate.

### Description of the Related Art

Semiconductor workpieces are generally manufactured with various respective layers formed on one or more respective surfaces of a semiconductor wafer or substrate. Generally, the semiconductor wafer or substrate is made of a silicon-based material, for example, a silicon carbide (SiC) material. For example, some semiconductor workpieces are manufactured to have a contact along a first surface of the SiC substrate or wafer, and the contact may be referred to as a backside contact. Generally, the backside contact includes one or more metal conductive layers that are stacked on one another. The backside contact is formed to provide electrical connections and pathways to and from active components that are present on a second surface of the SiC substrate or wafer that is opposite to the first surface. Generally, a lowermost metal conductive layer of the one or more metal conductive layers is adhered and directly coupled to the second surface of the SiC substrate or wafer. A resistivity results between the backside contact and the SiC substrate or wafer. The resistivity can be reduced based on the selection of metal conductive materials for forming the one or more metal conductive layers that are stacked on one another. However, there is a limit to which the resistivity between the backside contact and the SiC substrate or wafer can be reduced when utilizing the metal conductive layers. Furthermore, there are limits to an adhesion strength between the lowermost metal conductive layer of the one or more stacked metal conductive layers and the second surface of the SiC substrate or wafer to which the lowermost conductive layer is adhered or directly coupled.

### BRIEF SUMMARY

The present disclosure is directed to at least one embodiment of a semiconductor substrate or wafer structure that addresses the issues as set forth above. For example, at least one embodiment the semiconductor substrate or wafer structure is summarized as including a silicon carbide (SiC) substrate including a first surface and a second surface opposite to the first surface, one or more epitaxial layers and one or more device layers stacked on the first surface of the silicon carbide (SiC) substrate, a graphene layer on the second surface of the silicon carbide (SiC) substrate, the graphene layer being adhered and directly coupled the second surface of the silicon carbide (SiC) substrate, the graphene layer having randomly oriented layers that are transversely oriented to each other, and one or more metal conductive layers stacked on the graphene layer.

The present disclosure is directed to at least one embodiment of a method of manufacturing the at least one embodiment of the semiconductor substrate or wafer structure as set forth above. For example, at least one embodiment of the method of manufacturing is summarized as including forming one or more epitaxial layers and one or more device layers on a first surface of a silicon carbide (SiC) substrate. After forming the one or more epitaxial layers on the first surface of the silicon carbide (SiC) substrate, flipping the semiconductor substrate providing access to a second surface of the semiconductor substrate opposite to the first surface of the semiconductor substrate. After flipping the semiconductor substrate, grinding the second surface of the silicon carbide (SiC) substrate thinning the silicon carbide (SiC) substrate from a first thickness to a second thickness less than the first thickness. After grinding the second surface of the silicon carbide (SiC) substrate, forming a carbon coating layer fully covering and directly on the second surface of the semiconductor substrate. After forming the carbon coating on the second surface of the silicon carbide (SiC) substrate, converting the carbon coating to a graphene layer having randomly oriented layers that are transverse to each other, the graphene layer fully covering the second surface of the silicon carbide (SiC) substrate. After converting the carbon coating layer to the graphene layer having the randomly oriented layers, forming one or more metal conductive layers on the graphene layer forming a contact.

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility.
Figure 1A is a perspective side view of a wafer or substrate structure;
Figure 1B is a zoomed in, side view of section 1B-1B of the wafer or substrate structure as shown in Figure 1A;
Figure 2A is a perspective side view of a wafer or substrate structure including a graphene layer in accordance with some embodiments of the present disclosure;
Figure 2B is a zoomed in, side view of section 2B-2B of the wafer or substrate structure including the graphene layer in accordance with some embodiments of the present disclosure as shown in Figure 2A;
Figure 3 is a cross-sectional view of a graphene layer;
Figure 4 is a cross-sectional view of the graphene layer of the wafer or substrate structure in accordance with some embodiments of the present disclosure taken along a line 4-4 as shown in Figure 2A;
Figure 5 is a flowchart of an embodiment of a method of manufacturing of the present disclosure for manufacturing the wafer or substrate structure as shown in Figures 2A and 2B including the graphene layer as shown in Figure 4 in accordance with some embodiments of the present disclosure; and
Figures 6A-6H are perspective side views of respective steps of the flowchart of the embodiment of the method of manufacturing of the present disclosure for manufacturing the wafer or substrate structure as shown in Figures 2A and 2B including the graphene layer as shown in Figure 4 in accordance with some embodiments of the present disclosure.

### DETAILED DESCRIPTION

In the following description, certain details are set forth in order to provide a thorough understanding of various embodiments of devices, methods and articles. However, one of skill in the art will understand that other embodiments may be practiced without these details. In other instances, well-known structures and methods associated with, for example, silicon carbide substrates or layers (e.g., polycrystalline silicon carbide, monocrystalline silicon carbide, etc.), semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The semiconductor industry has been showing considerable interest in silicon carbide (SiC), in particular for the manufacture of electronic devices or components (e.g., diodes, transistors, or other similar power applications).

Generally, development and manufacture of silicon carbide (SiC) based electronic devices are limited by factors such as electrical and mechanical properties from forming silicon carbide (SiC) stacked substrate or wafer structures. When being processed or manufactured, one or more epitaxial layers and one or more device layers are formed on a frontside or first surface of a silicon carbide wafer or substrate. After the one or more epitaxial layers and the one or more device layers are formed on the frontside or first surface of the silicon carbide wafer or substrate, the silicon carbide wafer or substrate is flipped providing access to a backside or second surface of the silicon carbide wafer or substrate that is opposite to the frontside or first surface of the silicon carbide wafer or substrate. The backside or second surface can be grinded to thin the silicon carbide wafer or substrate to a selected thickness and then one or more metal conductive layers are formed on the backside or second surface of the silicon carbide wafer or substrate to form a backside contact. The one or more epitaxial layers and the one or more device layers are provided electrical signals through the backside contact and the silicon carbide wafer or substrate. A first metal conductive layer of the one or more metal conductive layers is adhered and directly coupled to the backside or second surface of the silicon carbide wafer or substrate. However, an adhesion strength of the first metal conductive layer to the backside or the second surface of the silicon carbide wafer or substrate can only be manufactured to be so strong and a resistivity between the one or more metal conductive layers and the silicon carbide wafer or substrate can be made so low. The adhesion strength only being capable of being made so strong between the first metal conductive layer and the backside or the second surface of the silicon carbide wafer or substrate being limited in strength results in a higher likelihood of peeling of the backside contact from the backside or the second surface of the silicon carbide wafer or substrate. The resistivity only being able to be made so low between the one or more metal conductive layers and the silicon carbide wafer or substrate limits a capacity of electrical signals that can readily pass through the silicon carbide wafer or substrate structure to provide operational characteristics as desired within a semiconductor device manufactured utilizing the silicon carbide wafer or substrate structure. In view of the above discussion, the present disclosure is directed to improving adhesion strength of a backside contact of a backside surface of a silicon carbide wafer or substrate and reducing a resistivity between the backside contact and the silicon carbide wafer or substrate by providing a graphene layer including randomly oriented layers between the backside surface of the silicon carbide wafer or substrate and the backside contact.

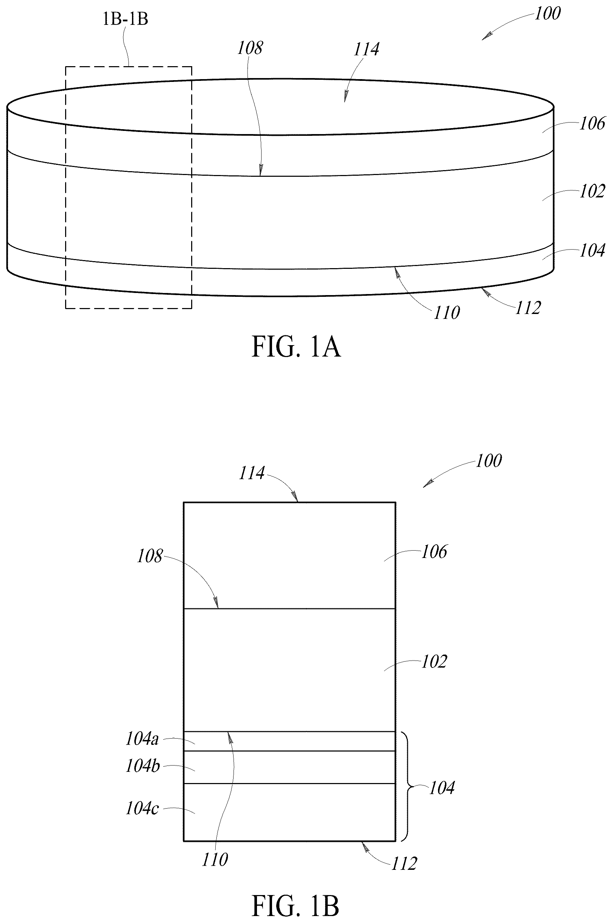

Figure 1A is a perspective view of a wafer or substrate structure 100. The silicon carbide substrate structure 100 includes a substrate 102, a backside contact 104, and one or more layers 106. The substrate 102 has a resistivity of 13-25 milliohms-centimeter (mohms-cm).

The substrate 102 includes a frontside surface or a first surface 108 and a backside surface or a second surface 110 opposite to the frontside surface or the first surface 108. The substrate 102 can be made of a silicon material such as a silicon carbide material.

The backside contact 104 is coupled to the second surface 110 of the substrate 102. The backside contact 104 is adhered and directly coupled to the second surface 110 of the substrate. The backside contact 104 includes a surface 112 that faces away from the substrate 102 and away from the one or more layers 106.

The one or more layers 106 includes one or more epitaxial layers and one or more device layers that are stacked on the first surface 106 of the substrate 102. The one or more layers 106 define one or more electrically active or passive components that are present at, along, and within the one or more layers 106. The one or more layers 106 includes a surface 114 that faces away from the substrate 102 and faces away from the backside contact 104. For example, the one or more electrically active components include at least one or more of integrated circuits, light-emitting diodes (LEDs), diodes, photodiodes, temperature sensors, pressure sensors, acceleration sensors, transistors, thyristors, or any other suitable type of electrically active component. For example, the one or more electrically passive components include at least one or more of resistors, capacitors, coils, or any other suitable type of electrically passive component.

Figure 1B is a zoomed in, side view of section 1B-1B of the substrate structure 100 as shown in Figure 1A. While the one or more layers 106 are shown as a single layer in Figure 1B, it will be readily appreciate that the one or more layers 106 includes the one or more epitaxial layers and the one or more device layers defining one or more electrically active or passive components within the one or more layers 106. Furthermore, as shown in Figure 1B, the backside contact 104 includes a plurality of metal conductive layers 104a, 104b, 104c. The plurality of metal conductive layers 104a, 104b, 104c are selected from various metal conductive materials known within the semiconductor industry such as aluminum, nickel, titanium, copper, silver, gold, or any other suitable type of metal conductive material or alloy suitable for forming a backside contact.

The plurality of metal conductive layers 104a, 104b, 104c includes a first metal conductive layer 104a, a second metal conductive layer 104b, and a third metal conductive layer 104c. The first metal conductive layer 104a is adhered and directly coupled to the second surface 110 of the substrate 102. The second metal conductive layer 104b is on the first metal conductive layer 104a. The third metal conductive layer 104c is on the second metal conductive layer 104b such that the second metal conductive layer 104b is sandwiched between the first metal conductive layer 104a and the third metal conductive layer 104c. One or more of the plurality of metal conductive layers 104a, 104b, 104c can be annealed in order to lower a contact resistance of the backside contact 104.

When the substrate structure 100 is exposed to thermal stresses (e.g., increases or decreases in temperature) or mechanical stresses (e.g., vibration, stress, strain, or some other similar or like type of mechanical stresses or strains), the likelihood of the backside contact 104 peeling from the second surface 110 of the substrate 102 is relatively high. When this peeling occurs and the substrate structure 100 is then further processed or refined in manufacturing semiconductor devices or packages, there is an increased likelihood of the semiconductor device or packages being manufactured outside of selected tolerances resulting in out-of-tolerance semiconductor devices or packages. These out-of-tolerance semiconductor devices or packages generally become waste, which results operation costs and waste costs of a semiconductor manufacturing plant (FAB) being increased. Accordingly, the present disclosure is directed to providing one or more embodiments of a substrate structure of the present disclosure that reduces or prevents peeling defects from occurring, which reduces operation costs and waste costs of the FAB.

A resistivity between the backside contact 104 and the second surface 110 of the substrate 102 at an interface between the first metal conductive layer 104a and the substrate 102 is within a range from 1*10⁻⁵ to 1*10⁻⁴ ohm-centimeters squared (ohm-cm²), or is equal to an upper end or a lower end of the range. In some cases, the resistivity is within a range from 1*10⁻⁶ to 1*10⁻⁵ ohm-centimeters squared (ohm-cm²), or is equal to an upper end or a lower end of the range. The resistivity between the backside contact 104 and the substrate 102 at the interface between the first metal conductive layer 104a and the second surface 110 of the substrate 102 limits a strength of electrical signals that can be efficiently and accurately communicated through the backside contact 104, the substrate 102, and the one or more layers 106. This limiting of the strength of electrical signals being capable of efficiently and accurately communicated through the backside contact 104, the substrate 102, and the one or more layers 106 due to the limiting resistivity at the interface between the first metal conductive layer 104a and the second surface 110 of the substrate 102 limits the types of semiconductor devices or packages that can be manufactured utilizing the substrate structure 100. Accordingly, the present disclosure is directed to providing one or more embodiments of a substrate structure of the present disclosure that reduces a resistivity between a backside contact and a substrate at an interface between the backside contact and the substrate increasing an efficiency and accuracy of electrical signals that can readily be communicated through the semiconductor substrate.

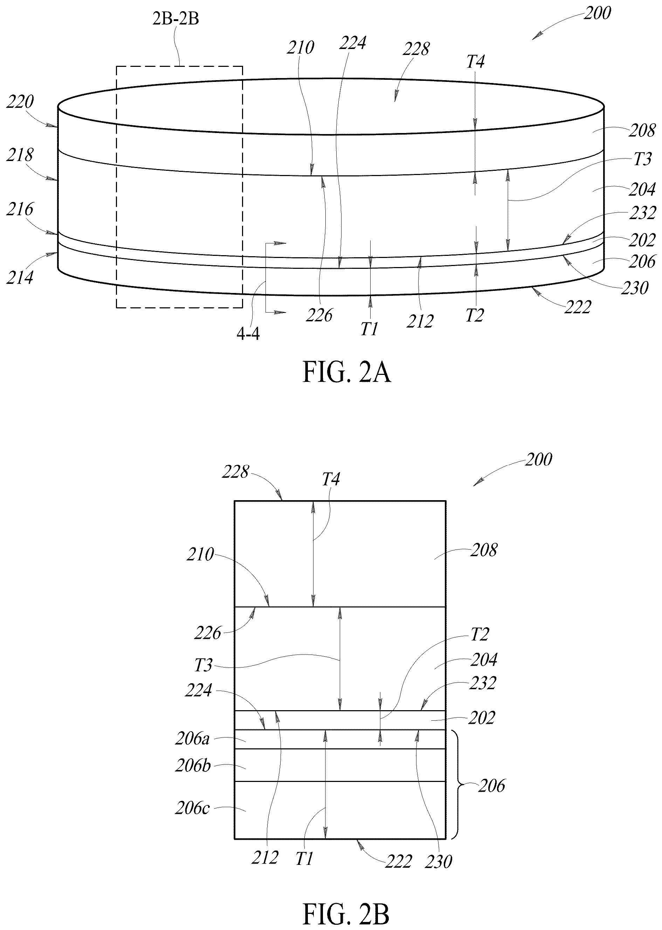

Figure 2A is a perspective side view of a wafer or substrate structure 200 including a intermediate graphene portion 202 in accordance with some embodiments of the present disclosure. The intermediate graphene portion 202 is referred to as a graphene layer 202. The substrate structure 200 includes a substrate 204, a backside contact 206, and one or more layers 208. The substrate 204 is the same or similar to the substrate 102, the backside contact 206 is the same or similar to the backside contact 104, and the one or more layers 208 are the same or similar to the one or more layers 106. In other words, the substrate 204 is a silicon carbide (SiC) substrate, the backside contact 206 is one or more metal conductive layers that are stacked on one another, and the one or more layers 208 are one or more epitaxial layers and one or more device layers that define one or more electrical active and passive components.

The substrate 204 includes a first surface 210 and a second surface 212 opposite to the first surface 210. The intermediate graphene portion 202 is adhered and coupled to the second surface 212, the backside contact is adhered and coupled to the intermediate graphene portion 202, and the one or more layers 208 are adhered to and coupled to the first surface 210 of the substrate 204.

A sidewall 214 of the backside contact 206, a sidewall 216 of the intermediate graphene portion 202, a sidewall 218 of the substrate, and a sidewall 220 of the one or more layers 208 that are coplanar and flush with each other and define a sidewall of the substrate structure 200. The backside contact 206 has a first surface 222 and a second surface 224 that is opposite to the first surface 222. The first surface 222 and the second surface 224 are transverse to the sidewall 214 of the backside contact 206, and the first surface 222 of the backside contact 206 faces away from the intermediate graphene portion 202, the substrate 204, and the one or more layers 208. The second surface 224 of the backside contact 206 is at an interface at which the intermediate graphene portion 202 and the backside contact 206 are coupled to each other and in physical contact with each other. The intermediate graphene portion 202 completely and fully covers the second surface 212 of the substrate 204 and fully and completely covers the second surface 224 of the backside contact 206. The intermediate graphene portion 202 completely and fully separates the backside contact 206 from the substrate 204 as the intermediate graphene portion 202 extends from the substrate 204 to the backside contact and fully and completely covers the respective surfaces of the substrate 204 and the backside contact 206, respectively.

The one or more layers 208 has a first surface 226 that is at an interface at which the substrate 204 and the one or more layers 208 are coupled to each other and in physical contact with each other. The one or more layers 208 further includes a second surface 228 opposite to the first surface 226, and the second surface 228 faces away from the substrate 204, the intermediate graphene portion 202, and the backside contact 206. For example, when the one or more layers 206 includes a plurality of layers, at least a lowermost respective layer of the plurality of layers is in physical contact and coupled to the second surface 210 of the substrate 204, and an uppermost respective layer of the plurality of layers at least partially defines the second surface 228.

The backside contact 206 has a first thickness T1 that extends from the first surface 222 to the second surface 224, and the first thickness T1 is within a range from 400 nanometers (nm) to 2000 nanometers (nm), or is equal to an upper end and a lower end of the range. The intermediate graphene portion 202 has a second thickness T2 that extends from the second surface 224 of the backside contact 206 to the first surface 212 of the substrate 204, and the second thickness T2 is within a range from 100 nanometers to 2000 nanometers, or is equal to an upper end and a lower end of the range, and is preferably within a range from 200 nanometers (nm) to 500 nanometers, or is equal to an upper end and a lower end of the range. The substrate 204 has a third thickness T3 that extends from the first surface 212 of the substrate 204 to the second surface 210 of the substrate, and the third thickness T3 is within a range from 50 micrometers (µm) to 500 micrometers (µm), or is equal to the upper and lower ends of this range, and is preferably within a range from 80 micrometers (µm) to 180 micrometers (µm), or is equal to an upper end and a lower end of the range. The one or more layers 208 has a fourth thickness T4 that extends from the first surface 226 of the one or more layers 208 to the second surface 228 of the one or more layers 208, and the fourth thickness T4 is within a range from 5 micrometers (µm) to 120 micrometers (µm), or is equal to an upper end or a lower end of the range.

In at least one embodiment of the substrate structure 200, the first thickness T1 is equal to 1000 nanometers (nm), the second thickness T2 is equal to 250 nanometers (nm), the third thickness T3 is equal to 180 micrometers (µm), and fourth thickness T4 is equal to 25 micrometers (µm). In at least one embodiment of the substrate structure 200, the first metal conductive layer 206a has a respective thickness equal to 100 nanometers (nm), the second metal conductive layer 206b has a respective thickness equal to 400 nanometers (nm), and the third metal conductive layer 206c has a respective thickness equal to 500 nanometers (nm).

Figure 2B is a zoomed in, side view of section 2B-2B of the substrate structure 200 in accordance with some embodiments of the present disclosure as shown in Figure 2A. While the one or more layers 208 are shown as a single layer in Figure 2B, it will be readily appreciated that the one or more layers 208 includes the one or more epitaxial layers and the one or more device layers defining one or more electrically active and passive components within the one or more layers 208. Furthermore, as shown in Figure 2B, the backside contact 206 includes a plurality of metal conductive layers 206a, 206b, 206c. The plurality of metal conductive layers 206a, 206b, 206c are selected from various metal conductive materials known within the semiconductor industry such as nickel, titanium, copper, silver, gold, or any other suitable type of metal conductive material or alloy suitable for forming a backside contact.

The plurality of metal conductive layers 206a, 206b, 206c includes a first metal conductive layer 206a, a second metal conductive layer 206b, and a third metal conductive layer 206c. The first metal conductive layer 206a is adhered and directly coupled to a lower surface 230 of the intermediate graphene portion 202, which is opposite to an upper surface 232 of the graphene layer 232 based on the orientation as shown in Figure 2B. The upper surface 232 is referred to as a first surface of the intermediate graphene portion 202, and the lower surface 230 is referred to as a second surface of the intermediate graphene portion 202.

The lower surface 230 of the intermediate graphene portion 202 is at the interface at which the intermediate graphene portion 202 and the backside contact 206 are coupled to each other and in physical contact with each other. More specifically, the lower surface 230 of the intermediate graphene portion 202 is at the interface between the intermediate graphene portion 202 and the first metal conductive layer 206a of the backside contact 206. In other words, the interface between the intermediate graphene portion 202 and the backside contact 206 is defined by the lower surface 230 of the intermediate graphene portion 202 and the second surface 224 of the backside contact 206.

The upper surface 232 of the intermediate graphene portion 202 is at the interface at which the intermediate graphene portion 202 and the substrate 204 are coupled to each other and in physical contact with each other. In other words, the interface between the intermediate graphene portion 202 and the substrate 204 is defined by the upper surface 232 of the intermediate graphene portion 202 and the first surface 212 of the substrate 204.

In at least one embodiment of the substrate structure 200, the first metal conductive layer 206a of the backside contact 206 is titanium (Ti), the second metal conductive layer 206b of the backside contact 206 is nickel (Ni), and the third metal conductive layer 206c of the backside contact is silver (Ag). As shown in Figure 2B, the second metal conductive layer 206b is sandwiched between the first metal conductive layer 206a and the third metal conductive layer 206c.

A first resistivity between the intermediate graphene portion 202 and the first metal conductive layer 206a at the interface between the intermediate graphene portion 202 and the first metal conductive layer 206a is within a range from 5*10⁻⁷ to 1*10⁻⁶ ohms-centimeters squared (ohm-cm²), or is equal to an upper end or a lower end of the range. A second resistivity between the intermediate graphene portion 202 and the substrate 204 at the interface between the intermediate graphene portion 202 and the substrate 204 is within a range from 5*10⁻⁷ to 1 * 10⁻⁶ ohms-centimeters squared (ohm-cm²), or is equal to an upper end or a lower end of the range. An overall or average resistivity that extends across the second thickness T2 of the intermediate graphene portion 202 is within a range from 1 * 10⁻⁶ to 5*10⁻⁶ ohms-centimeters (ohm-cm), or is equal to an upper end or a lower end of the range, and is preferable within a range from 1*10⁻⁶ to 3*10⁻⁶ ohms-centimeters (ohm-cm), or is equal to an upper end or a lower end of the range.

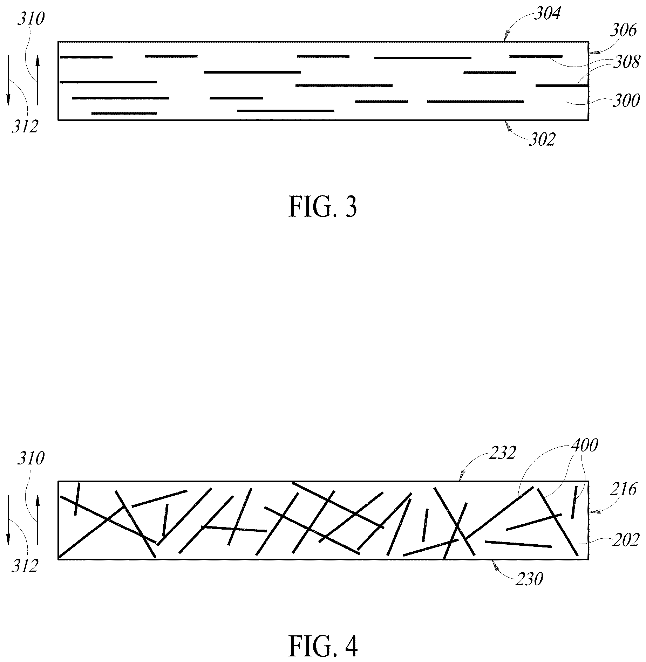

Figure 3 is a cross-sectional side view of a graphene portion 300. The graphene portion 300 includes a first surface 302, a second surface 304 opposite to the first surface 302, and a sidewall 306 that extends from the first surface 302 to the second surface 304 and that is transverse to the first surface 302 and the second surface 304. The graphene portion 300 is referred to as a graphene layer. The graphene portion 300 is made of a plurality of graphene layers or micro-layers 308 that are oriented parallel to each other and parallel to the first surface 302 and the second surface 304. The plurality of graphene layers 308 are perpendicular or orthogonal to the sidewall 306 of the graphene portion 300. The plurality of graphene layers 308 having the orientation as shown in Figure 3 results in the graphene portion 300 having a resistivity in a range from 1*10⁻² to 1 ohm-centimeter (ohm-cm), or equal to an upper end or a lower end of this range. This resistivity of the graphene portion 300 impedes an electrical signal that is passing through the graphene portion 300 in a first direction 310 directed away from the first surface 302 and towards the second surface 304 and a second direction 312 directed towards the first surface 302 and away from the second surface 304. The first direction 310 is represented by a first arrow 310 as shown in Figure 3, and the second direction 312 is represented by a second arrow 312 as shown in Figure 3.

Figure 4 is a cross-sectional side view of the intermediate graphene portion 202 of the substrate structure 200 in accordance with some embodiments of the present disclosure as shown in Figure 2A taken along line 4-4 as shown in Figure 2A. Unlike the graphene portion 300 that includes the plurality of graphene layers 308 that are parallel to the first surface 302 and the second surface 304 and is perpendicular or orthogonal to the sidewall 306, the intermediate graphene portion 202 includes a plurality of graphene layers 400 that are randomly oriented as shown in Figure 4. For example, the plurality of graphene layers 400 are randomly oriented such that at least some of the plurality of graphene layers 400 are transverse to the first surface 230, some are transverse to the second surface 232, and some are transverse to the sidewall 216 of the intermediate graphene portion 202. For example, some of the plurality of graphene layers 400 are transverse to all three of the first surface 230, the second surface 232, and the sidewall 216, are transverse to at least some combination of the first surface 230, the second surface 232, and the sidewall 216, and are transverse to at least one of the first surface 230, the second surface 232, and the sidewall 216. In other words, unlike the plurality of graphene layers 308 of the graphene portion 300 that are oriented parallel to the first surface 302, parallel to the second surface 304, and perpendicular or orthogonal to the sidewall 306, the plurality of graphene layers 400 of the intermediate graphene portion 202 are at least partially oriented extending in the first direction 310 and the second direction 312 allowing for an electrical signal to more readily pass through the intermediate graphene portion 202 as compared to when the electrical signal passes through the graphene portion 300. The graphene layer 400 has a resistivity within a range from 1 * 10⁻⁶ to 2 *10⁻⁶ ohms-centimeter (ohms-cm), or is equal to an upper end or a lower end of the range. The resistivity of the intermediate graphene portion 202 due to the random orientation of the plurality of graphene layers 400 making up the graphene layer 400 is lower than the resistivity of the graphene portion 300 meaning that an electrical signal passing through the intermediate graphene portion 202 is less impeded than when passing through the graphene portion 300.

If the graphene portion 300 was utilized in the substrate structure 200 instead of the intermediate graphene portion 202, a likelihood of peeling between the graphene portion 300 and the substrate 204 and a likelihood of peeling between the graphene portion 300 and the backside contact 206 is higher than when the graphene layer 400 is utilized instead. The graphene portion 300 has a higher likelihood of peeling occurring relative to the intermediate graphene portion 202 due to the graphene portion 300 having the plurality of graphene layers 308 oriented parallel to the first surface 302 and the second surface 304 unlike the plurality of graphene layers 400 of the intermediate graphene portion 202 that are randomly oriented. In other words, the random orientation of the plurality of graphene layers 400 of the intermediate graphene portion 202 allows for an adhesion strength at the interface between the intermediate graphene portion 202 and the substrate 204 an adhesion strength at the interface between the intermediate graphene portion 202 and the backside contact 206 to be greater than if the graphene portion 300 was utilized instead. In other words, the intermediate graphene portion 202 with the plurality of graphene layers 400 with the random orientation provides lower resistivity and stronger adhesion strength relative to the graphene portion 300 with the plurality of graphene layers 308 having the parallel orientation relative to the first surface 302 and the second surface of the graphene portion 300.

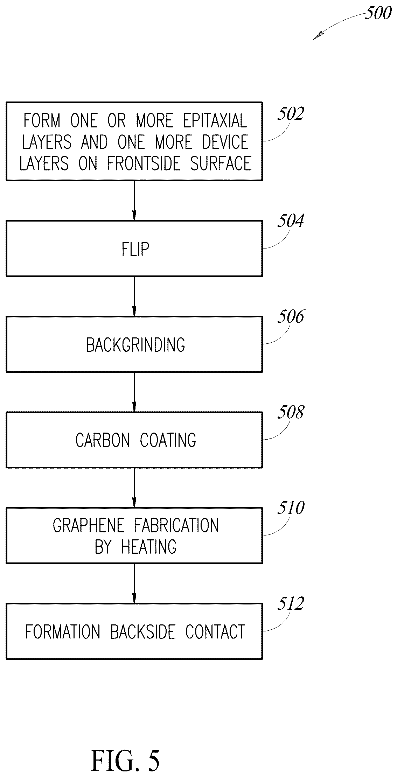

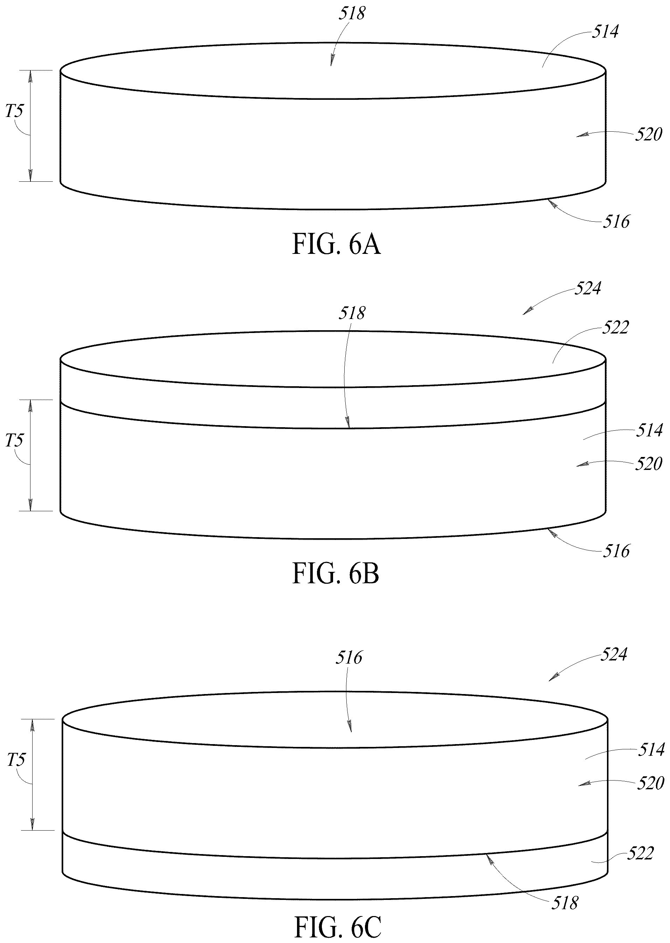

Figure 5 is directed to a flowchart 500 of a method of manufacturing the substrate structure 200 in accordance with some embodiments of the present disclosure as shown in Figures 2A and 2B of the present disclosure. Figures 6A-6H are perspective side views of respective steps of the flowchart 500 of the method of manufacturing the substrate structure 200 as shown in Figures 2A and 2B including the intermediate graphene portion 202 as shown in Figure 4 in accordance with some embodiments of the present disclosure. The details of Figures 6A-6H will be discussed in conjunction with carrying out respective steps of the flowchart 500.

The flowchart 500 includes a first step 502, a second step 504, a third step 506, a fourth step 508, a fifth step 510, and a sixth step 512. As shown in Figure 6A, a wafer or substrate 514, which is made of silicon-carbide (SiC), is provided and includes a first surface 516, a second surface 518 opposite to the first surface 516, and a sidewall 520 that extends from the first surface 516 to the second surface 518 and that is transverse to the first surface 516 and the second surface 518. The substrate 514 has a thickness T5 that extends from the first surface 516 to the second surface 518. The thickness T5 is in a range from 200 to 500 micrometers (µm), or is equal to an upper end or a lower end of the range. The substrate 514 corresponds to the substrate 204 of the substrate structure 200 in accordance with some embodiments of the present disclosure as shown in Figures 2A and 2B

In the first step 502, one or more layers 522 are formed on the second surface 518 of the substrate 514 forming an intermediate structure 524 as shown in Figure 6B. In at least one embodiment, the one or more layers 522 includes one or more epitaxial layers and one or more device layers. For example, the one or more epitaxial layers are epitaxially grown on one another and on the second surface and while forming these epitaxial layers respective patterning steps are carried out as well as deposition steps are carried out to form the one or more devices layers within, on, and along the one or more epitaxial layers. The one or more devices layers can be one or more conductive layers that are formed within the one or more epitaxial layers. When forming the one or more epitaxial layers and the one or more device layers, one or more temporary patterning layers or protective layers are formed on and removed to define and form one or more electrically active or passive devices that are present within, along, and at the one or more layers 522. The one or more layers 522 correspond to the one or more layers 208 of the substrate structure 200 in accordance with some embodiments of the present disclosure as shown in Figures 2A and 2B.

After the first step 502 in which the one or more layers 522 are formed on the second surface 518 of the substrate 514 forming the intermediate structure 524 as shown in Figure 6B, in a second step 504 the intermediate structure is reoriented by being flipped the results of which can be seen in Figure 6C. In at least one embodiment, the intermediate structure 524 is flipped utilizing a end effector of a transfer arm robot (TRA), a pick and place machine, or some other mechanical component, structure, or system capable of flipping the intermediate structure 524 from the orientation as shown in Figure 6B to the orientation of Figure 6C. Once the intermediate structure 524 has been flipped to be in the orientation as shown in Figure 6C, the first surface 516 is now readily accessible to perform processing steps at and along the first surface 516 of the substrate 514 of the intermediate structure 524.

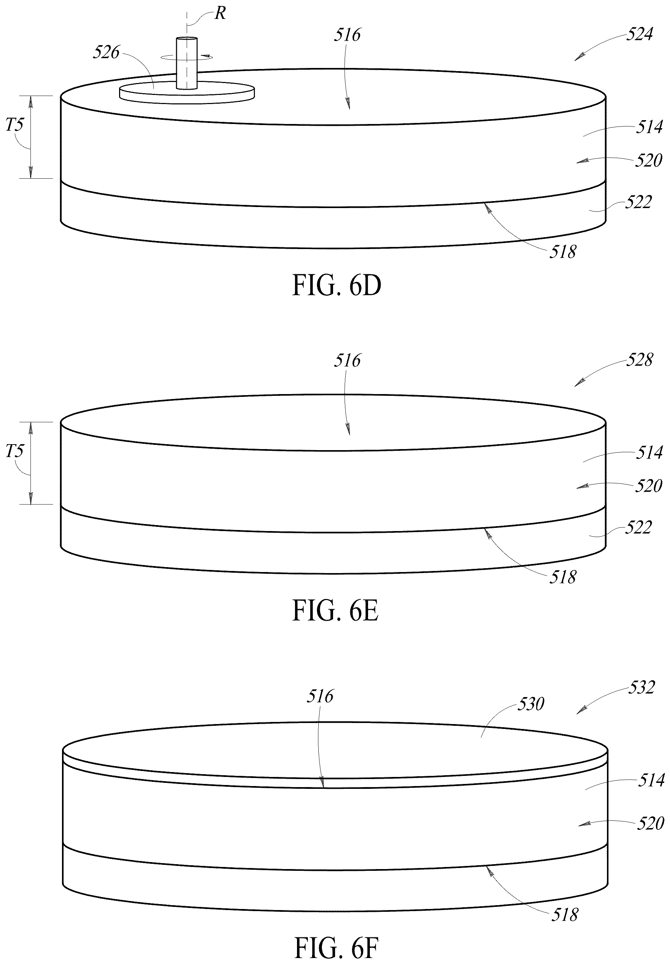

After the second step 504 in which the intermediate structure 524 is flipped from the orientation as shown in Figure 6B to the orientation as shown in Figure 6C, in a third step 506 a backgrinding or grinding is performed on the first surface 516 of the substrate 520 to thin and reduce the thickness T5 of the substrate 514 as shown in Figure 6D. The backgrinding or grinding is performed utilizing a grinding tool 526, which moves back and forth along the first surface 516 of the substrate 514 while rotating about a rotation axis R of the grinding tool 526. After the third step 506 has been completed, the result of the substrate 514 being thinned such that the thickness T5 has been reduced is readily seen in the intermediate structure 528 as shown in Figure 6E. After being thinned, the thickness T5 of the substrate is within a range from 50 to 350 micrometers (µm), or is equal to an upper end or a lower end of the range, or is preferably within a range from 80 to 180 micrometers (µm), or is equal to an upper end and a lower end of the range.

After the third step 506 in which the substrate 200 has been thinned reducing the thickness T5 of the substrate 514 as shown in Figures 6D and 6E, in a fourth step 508 a carbon coating 530 is formed on the first surface 516 of the substrate 514. The carbon coating 530 is made of a biocarbon material, organic carbon material, or any suitable type of carbon material (e.g., a waste material from a paper or pulp industry or some other suitable type of biocarbon, organic carbon material, or any other type of carbon material) that is deposited onto the second surface 518 of the substrate 514. For example, in at least some embodiments, the carbon coating material 530 is a bio-based or bio-based carbon material such as products from a forest materials or crop materials. In some embodiments, the carbon coating is a mixture of a combination of any one of the following of a carbon material, a graphitized or partial graphitized material, and a graphene material. The carbon coating 530 is formed on the first surface 516 of the substrate 514 by a deposition technique such as a spin-coating technique, a sputtering technique, a screen-printing technique, a chemical vapor deposition (CVD), or some other suitable technique known to the semiconductor industry for forming the carbon coating layer 530 on the first surface 516 of the substrate 514. The results of the carbon coating 530 being formed on the first surface 516 of the substrate 514 is readily seen in an intermediate structure 532 as shown in Figure 6F. In other words, the carbon coating 530 is formed directly and physically onto the surface 516 by depositing the biocarbon material, organic carbon material, or any suitable type of carbon material directly and physically onto the first surface 516 of the substrate 514.

For example, the biocarbon material, the organic carbon material, or any other suitable type of carbon material are of or include, for example, biomass such as wood, agricultural waste, sewage sludge, or some other suitable source of biomass that is capable of being heated in a low oxygen ambient environment to generate or create a carbon-rich biocarbon as a source for said biocarbon material, organic carbon material, or any other type of carbon or biocarbon material. It will be readily appreciated that other types of suitable biocarbon materials or organic carbon materials can be utilized.

When a screen-printing technique is utilized to form the carbon coating 530 on the first surface 516 of the substrate 514, a carbon material is deposited on a screen and the carbon material is then pressed through the screen with a blade or squeegee such that that carbon material is deposited uniformly and evenly along the first surface 514 of the substrate 514. Passing the carbon material through the screen results in the formation of the carbon coating 530 at and along the first surface of the substrate 514.

When a spin-coating technique is utilized to form the carbon coating 530 on the first surface of the substrate 514, a carbon material is deposited onto the first surface 516 of the substrate 514. Once the carbon material is deposited onto the first surface 516 of the substrate 514, the substrate 514 is spun resulting in the carbon material being spread out along the first surface 515 of the substrate 514 uniformly and evenly. In other words, spinning the substrate 514 after the carbon material has been deposited on the first surface 516 of the substrate results in the carbon coating 530 being formed on the first surface 516 of the substrate 514.

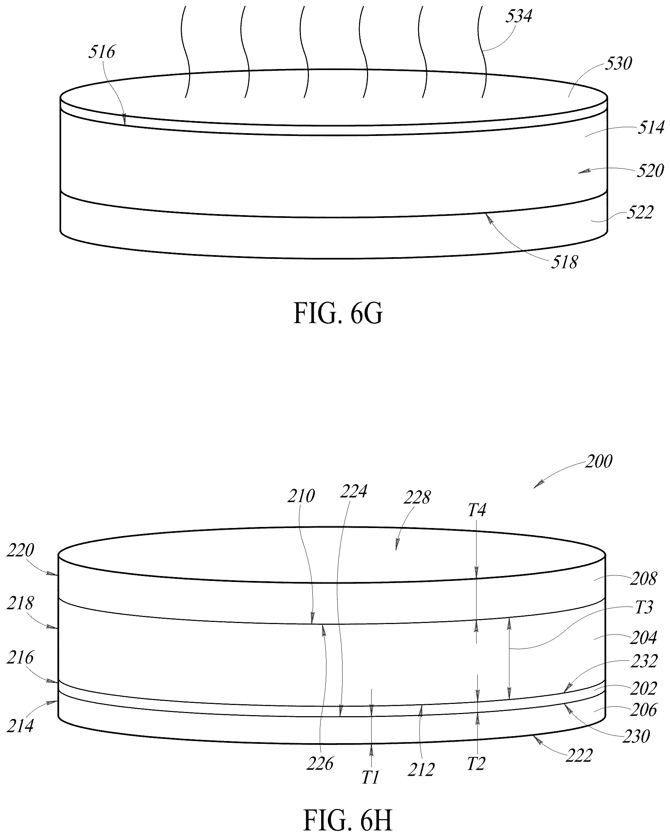

After the fourth step 508 in which the carbon coating 530 was formed on the first surface 516 of the substrate 514, in the fifth step 510 the carbon coating 530 is converted from the carbon coating into a graphite layer that is then converted into the intermediate graphene portion 202 by exposing the carbon coating to heat 534 provided from a heat source as shown in Figure 6G. The carbon coating 530 is converted to graphite and graphene by exposing the carbon coating 530 to a first temperature that is within a range from 1600 to 3000 degrees Celsius (°C), or equal to an upper end or a lower end of the range, and is preferably within a range from 2500 to 3000 degrees Celsius (°C). Alternatively, if the carbon coating 530 is being applied and is already graphitized, then the graphite carbon coating layer 530 is converted into graphene. In other words, the increase in temperature converts the carbon coating 530 to the intermediate graphene portion 202 having the plurality of graphene layers 400 with the random orientation as discussed earlier herein with respect to Figure 4 of the present disclosure.

In some embodiments, the heat source is a laser carrying out a laser annealing process to convert the carbon coating 530 to the intermediate graphene portion 202. When the heat source is the laser to carry out the laser annealing process, the laser increases the temperature of the carbon coating 530 within a range from 2500 to 3000 degrees Celsius (°C), or equal to an upper end or a lower end of this range. This converts the carbon coating, which is made from in at least one embodiment the bio-based carbon material, to a pure carbon material resulting in the formation of the intermediate graphene portion 202 with the randomly oriented plurality of graphene layers 400.

In some embodiments, the heat source is a microwave heat source for heating the carbon coating 530 utilizing microwaves. When the heat source is the microwave heat source for carrying out the microwave process, the microwave heat source increases the temperature of the carbon coating 530 within a range from 2000 to 3000 degrees Celsius (°C), or equal to an upper end or a lower end of this range. This converts the carbon coating, which is made of in at least one embodiment the bio-based carbon material, to a pure carbon material resulting in the formation of the intermediate graphene portion 202 with the randomly oriented plurality of graphene layers 400.

After the fifth step 510 in which the carbon coating has been converted into the intermediate graphene portion 202 with the plurality of graphene layers 202 that are randomly oriented, in a sixth step 512 a backside contact 536 is formed on the intermediate graphene portion 202 as shown in Figure 6H. The backside contact 536 corresponds to the backside contact 206 of the substrate structure 200 in accordance with some embodiments of the present disclosure as shown in Figures 2A and 2B. The backside contact 536 is formed by performing one or more deposition steps to deposit one or more metal conductive layers onto the intermediate graphene portion 202 or on one another. For example, in at least one embodiment, one or more sputtering and leveling processes and steps are performed in succession to form a plurality of metal conductive layers in a stacked formation along and on the first surface 230 of the intermediate graphene portion 202. After the backside contact 536 has been formed in the sixth step 512, the substrate structure 200 in accordance with some embodiments of the present disclosure as shown in Figures 2A and 2B is formed. The substrate structure 200 can then be further refined or processed within a semiconductor manufacturing plant (FAB) to manufacture or produce various types of semiconductor products, devices, or packages that benefit from the intermediate graphene portion 202 being present between the backside contact 206 and the substrate 204 of the substrate structure 200 as shown in Figures 2A and 2B.

After the sixth step 512 in which the backside contact 536 is formed on the intermediate graphene portion 202, the semiconductor structure 200 either undergoes further processing within a semiconductor manufacturing plant (FAB) and then is later singulated into individual die, or is singulated into individual die which are then complete or are further processed within the FAB. As the adhesion strength of the backside contact 206 to the intermediate graphene portion 202 (see Figures 2A and 2B of the present disclosure) is stronger than when the intermediate graphene portion 202 is present when it is not present, the likelihood of peeling of the backside contact 206 from the intermediate graphene portion 202 is significantly reduced when singulating as compared to when the backside contact 104 is directly adhered to a second surface 110 of the substrate 102 as shown in Figures 1A and 1B. In other words, the presence of the intermediate graphene portion 202 reduces or prevents edge peeling between the intermediate graphene portion 202, the backside contact 206, and the substrate 204 along edges that are formed when singulating the stacked structure as the adhesion strength between the backside contact 206 and the intermediate graphene portion 202 and the adhesion strength between the intermediate graphene portion 202 and the substrate 204 are strong enough to prevent or reduce the likelihood of delamination, peeling, partial peeling, partial delamination, or some other similar or like type of defect while singulating or, alternatively, during other processing steps. The adhesion strength being strong between the intermediate graphene portion 202, the backside contact 206, and the substrate 204 prevents or reduces the likelihood of delamination, peeling, partial peeling, partial delamination, or some other similar or like type of defect between the intermediate graphene portion 202, the backside contact 206, and the substrate 204 when exposed to thermal cycling during further processing of the stacked substrate structure 200. Similarly, the adhesion strength being strong between the intermediate graphene portion 202, the backside contact 206, and the substrate 204 prevents delamination, peeling, partial peeling, partial delamination, or some other similar or like type of defect from occurring when manufactured semiconductor devices or products that include the respective portions of the intermediate graphene portion 202, the backside contact 206, and the substrate 204 (*e.g.,* portions were singulated from the stacked substrate structure 200) is exposed to thermal cycling such as a working or operation environment in which the semiconductor devices or products are utilized. While this delamination or peeling may not be readily visible with the naked eye, it is readily determined by measuring a resistivity of the stacked substrate structure 200 as will be discussed as follows herein.

The adhesion strength between the intermediate graphene portion 202, the backside contact 206, and the substrate 204 is determined to be strong as the intermediate graphene portion 202, the backside contact 206, and the substrate 204 can be exposed to 350 degrees Celsius (°C) without any peeling occurring between the intermediate graphene portion 202 and the backside contact 206 and without any peeling occurring between the intermediate portion 202 and the backside contact 206. It will be readily appreciated that when the resistivity of the stacked substrate structure 200 is higher, the adhesion strength between the intermediate graphene portion 202, the backside contact 206, and the substrate 204 is lower, and, oppositely, when the resistivity of the backside contact 206 is lower, the adhesion strength between the intermediate graphene portion 202, the backside contact 206, and the substrate 204 is higher. In other words, the resistivity of the stacked substrate structure 200 is measured to determine the adhesion strength between the respective layers of the stacked substrate structure 200, and, particularly, determine the adhesion strength between the intermediate graphene portion 202, the backside contact 206, and the substrate 204. Furthermore, as it is found that the resistivity is lowered by the presence of the intermediate graphene portion 202 with the randomly oriented layers (see Figure 4B of the present disclosure), electrical signals more readily, efficiently, and accurately pass through the stacked substrate structure 200 as compared to a respective stacked substrate structure that does not include the graphene layer (*i.e.,* see the stacked substrate structure 100 as shown in Figures 1A and 1B of the present disclosure).

In view of the discussion herein, providing the intermediate graphene portion 202 in the stacked substrate structure 200 as shown in Figures 2A and 2B reduces a number of semiconductor products or devices that become waste resulting in increased output of a semiconductor manufacturing plant (FAB). Reducing the waste and increasing the output results in the semiconductor manufacturing plant (FAB) providing a greater number of semiconductor devices and packages provided to consumers.

In view of the discussion herein, the intermediate graphene portion 202 within the semiconductor substrate structure 200 prevents peeling or delamination defects and provides a lower resistivity as shown in Figures 2A and 2B as compared to when a graphene layer is not present such as the semiconductor substrate structure 100 as shown in Figures 1A and 1B of the present disclosure or when a graphene layer has a plurality of graphene layers that are all parallel with each other (see, for example, Figure 3 in which the plurality of graphene layers 308 are all parallel with each other). The resistivity is lower when the intermediate graphene portion 202 is present due to random orientation of the plurality of graphene layers 400. For example, the plurality of graphene layers 400 have an orientation that is transverse to the first direction 310 and the second direction 312 providing electrical pathways that are more readily oriented and capable of transferring respective electrical signals in the first direction 310 and the second direction 312 due to the reduced resistivity along these direction as compared to graphene portion 300 with the plurality of graphene layers 308 that are all parallel with each other and perpendicular or orthogonal to the first direction 310 and the second direction 312. In other words, the plurality of graphene layers 400 having some vertical orientation provides the electrical signals electrical pathways along which less resistance occurs resulting in the electrical signals to more readily effectively, efficiently, and accurately pass along and through the intermediate graphene portion 202 as compared to the intermediate graphene portion 202.

The partial vertical orientation or transverse orientation of the plurality of graphene layers 400 of the intermediate graphene portion 202 results in stronger adhesion with the backside contact 206 and the substrate 204 as compared to when no graphene layer is present or when the graphene portion 300 is utilized instead. The vertical orientation or transverse orientation of the plurality of graphene layers 400 that make up the intermediate graphene portion 202 allow for the surfaces to be more readily adhered together robustly, which reduces the likelihood of peeling when no graphene layer is present or the graphene portion 300 is instead utilized to couple together a substrate and a backside contact.

At least one embodiment of a device of a present disclosure is summarized as including: a silicon carbide (SiC) substrate including a first surface and a second surface opposite to the first surface; one or more epitaxial layers and one or more device layers stacked on the first surface of the silicon carbide (SiC) substrate; a graphene layer on the second surface of the silicon carbide (SiC) substrate, the graphene layer being adhered and directly coupled the second surface of the silicon carbide (SiC) substrate, the graphene layer having randomly oriented layers that are transversely oriented to each other; and one or more metal conductive layers stacked on the graphene layer.

In at least some embodiments, the graphene layer is made pure carbon.

In at least some embodiments, the graphene layer is made of a majority of graphene.

In at least some embodiments, the graphene layer has a thickness that is within a range from 100 to 2000 nanometers (nm), or is equal to an upper end and a lower end of the range.

In at least some embodiments, the silicon carbide substrate has a thickness that is within a range from 50 to 500 micrometers (µm), or is equal to an upper end and a lower end of the range.

In at least some embodiments, a resistivity between the graphene layer and the silicon carbide (SiC) substrate is within a range from 5*10⁻⁷ to 1 * 10⁻⁶ ohms-centimeters squared (ohms-cm²), or is equal to an upper end or a lower end of the range.

In at least some embodiments, a resistivity between the graphene layer and the contact is within a range from 5*10⁻⁷ to 1 * 10⁻⁶ ohms-centimeters squared (ohms-cm²), or is equal to an upper end or a lower end of the range.

In at least some embodiments, the graphene layer fully and completely covers the second surface of the silicon carbide (SiC) substrate.

In at least some embodiments, the one or more conductive layers are fully and completely separated by the graphene layer from the second surface of the silicon carbide (SiC) substrate.

In at least some embodiments, the one or more conductive layers includes a first metal conductive layer made of a titanium material that is adhered and directly coupled to the graphene layer.

In at least some embodiments, the one or more conductive layers further includes: a second metal conductive layer on the first metal conductive layer, the second metal conductive layer being made of a nickel material; and a third metal conductive layer on the second metal conductive layer, the third metal conductive layer being made of silver material.

At least one embodiment of a method of the present disclosure is summarized as including: forming one or more epitaxial layers and one or more device layers on a first surface of a silicon carbide (SiC) substrate; after forming the one or more epitaxial layers on the first surface of the silicon carbide (SiC) substrate, flipping the semiconductor substrate providing access to a second surface of the semiconductor substrate opposite to the first surface of the semiconductor substrate; after flipping the semiconductor substrate, grinding the second surface of the silicon carbide (SiC) substrate thinning the silicon carbide (SiC) substrate from a first thickness to a second thickness less than the first thickness; after grinding the second surface of the silicon carbide (SiC) substrate, forming a carbon coating layer fully covering and directly on the second surface of the semiconductor substrate; after forming the carbon coating on the second surface of the silicon carbide (SiC) substrate, converting the carbon coating to a graphene layer having randomly oriented layers that are transverse to each other, the graphene layer fully covering the second surface of the silicon carbide (SiC) substrate; after converting the carbon coating layer to the graphene layer having the randomly oriented layers, forming one or more metal conductive layers on the graphene layer forming a contact.

In at least some embodiments, converting the carbon coating layer to the graphene layer having randomly oriented layers that are transverse to each other further includes laser annealing the carbon coating layer.

In at least some embodiments, converting the carbon coating layer to the graphene layer having randomly oriented layers that are transverse to each other further includes microwave heating the carbon coating layer.

In at least some embodiments, the carbon coating is made of a bio-based carbon material.

In at least some embodiments, the graphene layer is pure carbon.

In at least some embodiments, the graphene layer has a thickness within a range from 100 to 2000 nanometers (nm), or is equal to an upper end and a lower end of the range.

At least one embodiment of a method of the present disclosure is summarized as including: grinding a surface of a silicon carbide (SiC) substrate, forming a carbon coating layer fully covering and directly on the surface of the semiconductor substrate; after forming the carbon coating on the second surface of the silicon carbide (SiC) substrate, converting the carbon coating to a graphene layer having randomly oriented layers that are transverse to each other, the graphene layer fully covering the second surface of the silicon carbide (SiC) substrate; and after converting the carbon coating layer to the graphene layer having the randomly oriented layers, forming one or more metal conductive layers on the graphene layer forming a contact.

In at least some embodiments, the carbon coating is made of a bio-based carbon material.

In at least some embodiments, converting the carbon coating layer to the graphene layer having randomly oriented layers that are transverse to each other further includes at least one of microwave heating the carbon coating layer or laser annealing the carbon coating layer.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device (200), comprising:
a silicon carbide, SiC, substrate (204) including a first surface (210) and a second surface (212) opposite to the first surface;
one or more epitaxial layers and one or more device layers (208) stacked on the first surface of the SiC substrate;
a graphene layer (202) on the second surface of the SiC substrate, the graphene layer being adhered and directly coupled the second surface of the SiC substrate, the graphene layer having randomly oriented layers (400) that are transversely oriented to each other; and
one or more metal conductive layers (206) stacked on the graphene layer.

2. The device of claim 1, wherein the graphene layer (202) is made pure carbon, or wherein the graphene layer is made of a majority of graphene.

3. The device of claim 1 or 2, wherein the graphene layer (202) has a thickness (T2) that is within a range from 100 to 2000 nm, or is equal to an upper end and a lower end of the range.

4. The device of anyone of the preceding claims, wherein the SiC substrate (204) has a thickness (T3) that is within a range from 80 to 180 µm, or is equal to an upper end and a lower end of the range.

5. The device of anyone of the preceding claims, wherein a resistivity between the graphene layer (202) and the SiC substrate (204) is within a range from 5*10⁻⁷ to 1 * 10⁻⁶ ohms-cm², or is equal to an upper end or a lower end of the range.

6. The device of anyone of the preceding claims, wherein a resistivity between the graphene layer (202) and the contact (206) is within a range from 5*10⁻⁷ to 1 * 10⁻⁶ ohms-cm², or is equal to an upper end or a lower end of the range.

7. The device of anyone of the preceding claims, wherein the graphene layer (202) fully and completely covers the second surface (212) of the SiC substrate (204).

8. The device of claim 7, wherein the one or more conductive layers (206) are fully and completely separated by the graphene layer (202) from the second surface (212) of the SiC substrate (204).

9. The device of anyone of the preceding claims, wherein the one or more conductive layers (206) includes a first metal conductive layer (206a) made of a titanium material that is adhered and directly coupled to the graphene layer (202).

10. The device of claim 9, wherein the one or more conductive layers (206) further includes:
a second metal conductive layer (206b) on the first metal conductive layer (206a), the second metal conductive layer being made of a nickel material; and
a third metal conductive layer (206c) on the second metal conductive layer, the third metal conductive layer being made of silver material.

11. A method (500), comprising in the order the steps of:
forming (502, 522) one or more epitaxial layers and one or more device layers on a first surface of a SiC substrate;
flipping (504) the semiconductor substrate providing access to a second surface of the semiconductor substrate opposite to the first surface of the semiconductor substrate;
grinding (506) the second surface of the SiC substrate thinning the SiC substrate from a first thickness to a second thickness less than the first thickness;
forming (508) a carbon coating layer fully covering and directly on the second surface of the semiconductor substrate;
converting (510) the carbon coating to a graphene layer having randomly oriented layers that are transverse to each other, the graphene layer fully covering the second surface of the SiC substrate; and
forming (512) one or more metal conductive layers on the graphene layer forming a contact.

12. The method of claim 11, wherein converting (510) the carbon coating layer to the graphene layer having randomly oriented layers that are transverse to each other further includes laser annealing the carbon coating layer;
alternatively, wherein converting (510) the carbon coating layer to the graphene layer having randomly oriented layers that are transverse to each other further includes microwave heating the carbon coating layer.

13. A method, comprising the steps of :
grinding (506) a surface of a silicon carbide, SiC, substrate;
forming (508) a carbon coating layer fully covering and directly on the surface of the semiconductor substrate;
after forming the carbon coating on the second surface of the SiC substrate, converting (510) the carbon coating to a graphene layer having randomly oriented layers that are transverse to each other, the graphene layer fully covering the second surface of the SiC substrate; and
after converting the carbon coating layer to the graphene layer having the randomly oriented layers, forming (512) one or more metal conductive layers on the graphene layer forming a contact.

14. The method of claim 13, wherein the carbon coating is made of a bio-based carbon material.

15. The method of claim 13 or 14, wherein converting (510) the carbon coating layer to the graphene layer having randomly oriented layers that are transverse to each other further includes at least one of microwave heating the carbon coating layer or laser annealing the carbon coating layer.
